(19) **Europäisches Patentamt / European Patent Office / Office européen des brevets**

(11) **EP 3 736 585 B1**

(12) **EUROPEAN PATENT SPECIFICATION**

(45) Date of publication and mention
of the grant of the patent:
**15.04.2026 Bulletin 2026/16**

(21) Application number: **20165062.9**

(22) Date of filing: **23.03.2020**

(51) International Patent Classification (IPC):
**G01R 31/36** (2020.01)

(52) Cooperative Patent Classification (CPC):
**G01R 31/3647; H01M 10/48;** G01R 31/367;
Y02E 60/10; Y02T 10/70

(54) **METHOD AND DEVICE FOR PREDICTING PEAK POWER OF BATTERY**

VERFAHREN UND VORRICHTUNG ZUR VORHERSAGE DER SPITZENLEISTUNG EINER BATTERIE

MÉTHODE ET DISPOSITIF POUR PRÉDIRE LA PUISSANCE DE CRÊTE D'UNE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.05.2019 CN 201910385509**

(43) Date of publication of application:
**11.11.2020 Bulletin 2020/46**

(73) Proprietor: **SAIC MOTOR Corporation Limited**
**Shanghai 201203 (CN)**

(72) Inventors:
• **SHI, Quan**
**Shanghai, Shanghai 200438 (CN)**
• **YAN, Chenxing**
**Shanghai, Shanghai 200438 (CN)**
• **ZHANG, Zhiyun**
**Shanghai, Shanghai 200438 (CN)**
• **WANG, Qianqian**
**Shanghai, Shanghai 200438 (CN)**
• **JING, Yan**
**Shanghai, Shanghai 200438 (CN)**
• **DING, Xiao**
**Shanghai, Shanghai 200438 (CN)**
• **ZHANG, Wang**
**Shanghai, Shanghai 200438 (CN)**
• **CHENG, Kai**
**Shanghai, Shanghai 200438 (CN)**
• **SHANG, Dan**
**Shanghai, Shanghai 200438 (CN)**

(74) Representative: **HGF**
**HGF BV**
**Benoordenhoutseweg 46**
**2596 BC The Hague (NL)**

(56) References cited:
EP-A1- 2 894 486          US-A1- 2012 101 674
US-A1- 2016 052 418

• HU XIAOSONG ET AL: "Model-Based Dynamic Power Assessment of Lithium-Ion Batteries Considering Different Operating Conditions", IEEE TRANSACTIONS ON INDUSTRIAL INFORMATICS, IEEE SERVICE CENTER, NEW YORK, NY, US, vol. 10, no. 3, 1 August 2014 (2014-08-01), pages 1948 - 1959, XP011555966, ISSN: 1551-3203, [retrieved on 20140804], DOI: 10.1109/TII.2013.2284713
• CAI-PING ZHANG ET AL: "Estimation of Real-Time Peak Power Capability of a Traction Battery Pack Used in an HEV", POWER AND ENERGY ENGINEERING CONFERENCE (APPEEC), 2010 ASIA-PACIFIC DATE OF CONFERENCE: 28-31 MARCH 2010, IEEE, PISCATAWAY, NJ, USA, 28 March 2010 (2010-03-28), pages 1 - 6, XP031658674, ISBN: 978-1-4244-4812-8
• DUONG T Q: "USABC and PNGV test procedures", JOURNAL OF POWER SOURCES, ELSEVIER SA, CH, vol. 89, no. 2, 1 August 2000 (2000-08-01), pages 244 - 248, XP004201957, ISSN: 0378-7753, DOI: 10.1016/S0378-7753(00)00439-0

EP 3 736 585 B1

- **PEI LEI ET AL: "Online peak power prediction based on a parameter and state estimator for lithium-ion batteries in electric vehicles", ENERGY, ELSEVIER, AMSTERDAM, NL, vol. 66, 22 February 2014 (2014-02-22), pages 766 - 778, XP028634294, ISSN: 0360-5442, DOI: 10.1016/ J.ENERGY.2014.02.009**

**Description**

**Technical field**

The present application relates to the technical field of batteries and, in particular, to a method and device for predicting a peak power of the batteries.

**Background Art**

With rapid development of economy, electric vehicles have been increasingly widely used, and development of power batteries, as power sources or auxiliary power sources of the electric vehicles, becomes particularly important. Prediction of a peak power (State of Power, SOP) of the power batteries is one of challenges encountered for the electric vehicles. Among them, a power battery power includes a discharge power and a charging power. Generally, a maximum discharge power and a maximum charge power are defined as the peak power of the battery if a voltage, a state of charge (SOC) and a current of the battery do not exceed their respective limits for a period of time.

Currently, methods of predicting a peak power of a battery prediction generally include an offline test table method and a method for predicting the peak power of the battery based on a dynamic electrochemical model of the battery. The offline test table method sets forth the principle of power prediction very well, but it employs a too simple model in which only a voltage factor is considered. The fact that constraint of the SOC is not considered in this method causes the predicted power to be greater than its actual value, and over charge and over discharge phenomena may occur in the battery. This may cause safety problems and affect life of a battery pack. In addition, this method involves a large amount of experimental work, including a large number of tests to complete the charge-discharge power table as well as tests under different life states which is particularly difficult to complete. Meanwhile, contends in the table in this method are obtained through offline tests, which results in relatively poor adaptability in online applications, and in particular, a temperature change of the battery in use and battery attenuation are not considered in this method.

The method of predicting the peak power of the battery based on the dynamic electrochemical model of the battery fails to dynamically identify a parameter of a battery model. During successive sampling cycles, integral calculations need to be introduced into formulas, which causes related calculations more complicated and a substantially increased amount of calculations. Further relevant approaches for calculating a peak power of a battery are described in documents US 2016052418A1, EP 2 894 486 A1, "Model-Based Dynamic Power Assessment of Lithium-Ion Batteries Considering Different Operating Conditions", HU XIAOSONG ET AL, IEEE TRANSACTIONS ON INDUSTRIAL INFORMATICS, NY, US, vol. 10, no. 3, 1 August 2014, pages 1948-1959 and "Estimation of Real-Time Peak Power Capability of a Traction Battery Pack Used in an HEV", CAI-PING ZHANG ET AL, POWER AND ENERGY ENGINEERING CONFERENCE (APPEEC), 2010 ASIA-PACIFIC DATE OF CONFERENCE: 28-31 MARCH 2010, NJ, USA, 28 March 2010, pages 1-6.

Therefore, how to predict the peak power of the battery accurately using a more advanced method is a problem to be solved, so as to effectively avoid the over charge and over discharge phenomena of the power battery and protect the battery better while reducing complexity of prediction models and the amount of calculations.

Summary of the Invention

The invention is defined by a method for predicting a peak power of a battery, comprising: providing a target battery to be predicted; calculating a 10s equivalent resistance value of the target battery using a pre-built 10s equivalent resistance calculation formula; predicting a first peak power of the target battery based on the 10s equivalent resistance value of the target battery; calculating the peak power of the target battery under a HPPC condition as a second peak power; and selecting the smaller one of the first peak power and the second peak power as the peak power of the target battery, wherein building the 10s equivalent resistance calculation formula comprises: providing a first-order RC power battery model as a dynamic model of a power battery system; deriving the following difference equation of the dynamic model of the power battery system as a model formula of the dynamic model of the power battery system:

$$\mathrm{U}_{d,k+1} = aU_{d,k} + bI_{L,k+1} + cI_{L,k};$$

and

deriving the following 10s equivalent resistance calculation formula based on the model formula of the dynamic model of the power battery system using a constant current iteration method:

$$R = a^{10}b + (a^9 + a^8 + a^7 + a^6 + a^5 + a^4 + a^3 + a^2 + a + 1)\,(b+c),$$

wherein calculating the 10s equivalent resistance value of the target battery using the pre-built 10s equivalent resistance calculation formula comprises:

calculating parameter values a, b and c in the 10s equivalent resistance calculation formula using a recursive least squares algorithm of a forgetting factor; and
calculating the 10s equivalent resistance value of the target battery by putting the parameter values into the 10s equivalent resistance calculation formula, and
wherein predicting the first peak power of the target battery based on the 10s equivalent resistance value of the target battery comprises:

calculating a maximum charge current and a maximum discharge current of the target battery based on the 10s equivalent resistance value of the target battery $R_d$, a rated voltage of the target battery $U_{max}$ and a cut-off voltage of the target battery $U_{min}$, and an open circuit voltage of the target battery $U_{ocv}$, wherein the maximum discharge current $Id_{dis}$ and maximum charge current $Id_{cha}$ are calculated by:

$$Id_{dis} = \frac{U_{min} - U_{ocv}}{R_d},$$

$$Id_{cha} = \frac{U_{max} - U_{ocv}}{R_d},$$

and predicting the first peak power of the target battery based on the maximum charge current and the maximum discharge current of the target battery and the 10s equivalent resistance value of the target battery, wherein the predicted first peak power is calculated by:

$$Power = Id_{dis} * U_{min}$$

$$Power = Id_{cha} * U_{max}.$$

A further aspect of the invention is defined by a device for predicting a peak power of a battery, comprising: a first obtaining unit configured for providing a target battery to be predicted; a calculating unit configured for calculating a 10s equivalent resistance value of the target battery using a pre-built 10s equivalent resistance calculation formula; a predicting unit configured for predicting a first peak power of the target battery based on the 10s equivalent resistance value of the target battery; a second obtaining unit configured for calculating the peak power of the target battery under a HPPC condition as the second peak power; a first acquiring unit configured for selecting the smaller one of the first peak power and the second peak power as the peak power of the target battery; a building unit for providing a first-order RC power battery model as a dynamic model of a power battery system; a third obtaining unit configured for deriving the following difference equation of the dynamic model of the power battery system as a model formula of the dynamic model of the power battery system:

$$U_{d,k+1} = aU_{d,k} + bI_{L,k+1} + cI_{L,k};$$

and
a second acquiring unit configured for deriving the following 10s equivalent resistance calculation formula based on the model formula of the dynamic model of the power battery system using a constant current iteration method:

$$R = a^{10}b + (a^9 + a^8 + a^7 + a^6 + a^5 + a^4 + a^3 + a^2 + a + 1)\,(b+c),$$

wherein the calculating unit comprises:

a parameter value determining subunit configured for calculating parameter values a, b and c in the 10s equivalent resistance calculation formula using a recursive least squares algorithm of a forgetting factor; and

a resistance value calculating subunit configured for calculating the 10s equivalent resistance value of the target battery by putting the parameter values into the 10s equivalent resistance calculation formula, and
wherein the predicting unit comprises:

a current calculating subunit configured for calculating a maximum charge current and a maximum discharge current of the target battery based on the 10s equivalent resistance value of the target battery $R_d$, a rated voltage of the target battery $U_{max}$ and a cut-off voltage of the target battery $U_{min}$, and an open circuit voltage of the target battery $U_{ocv}$, wherein the maximum discharge current $Id_{dis}$ and maximum charge current $Id_{cha}$ are calculated by:

$$Id_{dis} = \frac{U_{min} - U_{ocv}}{R_d},$$

$$Id_{cha} = \frac{U_{max} - U_{ocv}}{R_d},$$

and
a power predicting subunit configured for predicting the first peak power of the target battery based on the maximum charge current and the maximum discharge current of the target battery and the 10s equivalent resistance value of the target battery, wherein the predicted first peak power is calculated by:

$$Power = Id_{dis} * U_{min}$$

$$Power = Id_{cha} * U_{max}.$$

Further aspects are defined by the corresponding dependent claims.

**Brief Description of the Drawings**

In order to describe the technical solutions in the embodiments of the present application or in the prior art more clearly, the drawings used in the description of the embodiments or of the prior art are briefly introduced below. Obviously, the drawings in the following description show some embodiments of the present application, and, for skills ordinary in the art, other drawings can be obtained according to these drawings without paying creative labor.

FIG. 1 is a schematic flowchart of a method for predicting a peak power of a battery provided in an embodiment of the present application;
FIG. 2 is a schematic diagram of a power battery model provided in an embodiment of the present application;
FIG. 3 is one of schematic diagrams of a 10s peak charge and discharge power provided in an embodiment of the present application;
FIG. 4 is another of schematic diagrams of the 10s peak charge and discharge power provided in the embodiment of the present application;
FIG. 5 is an overall schematic diagram for implementing a method for predicting a peak power of a battery provided in an embodiment of the present application;
FIG. 6 is a detail schematic diagram for implementing a method for predicting a peak power of a battery provided in an embodiment of the present application; and
FIG. 7 is a structural schematic diagram of a device for predicting a peak power of a battery provided in an embodiment of the present application.

**Detailed Description of Preferred Embodiments**

In order to make the foregoing objects, features and advantages of the present application more comprehensible, the embodiments of the present application will be further described in detail below with reference to the accompanying drawings and specific implementations.
In order to facilitate understanding of the technical solutions provided in the present application, brief description will be given with regard to the background of the technical solutions in the present application.
As we all know, energy conservation, environmental protection and safety are emphasis for development of future cars. With rapid development of economy and improvement of people's awareness of environmental protection, electric vehicles have been increasing widely used. One of challenges for the electric vehicles is evaluation of SOC and SOP of a power battery, and accurate prediction of the power battery SOC is an important part in design of the power battery and an important basis for power matching and performance design at an early stage of design of the electric vehicle.

Existing methods for predicting a peak power of a battery generally include an offline test table method and a method for predicting the peak power of the battery based on a dynamic electrochemical model of the battery. Among these, the offline test table method employs a too simple model in which only a voltage factor is considered. The fact that constraint of SOC is not considered in this method causes the predicted power to be greater than its actual value, and over charge and over discharge phenomena may occur in the battery. This may cause safety problems easily and affect life of a battery pack. In addition, this method involves a large amount of experimental work, including a large number of tests to complete the charge-discharge power table as well as tests in different life states which is particularly difficult to complete. Meanwhile, contends in the table in this method are obtained through offline tests, which results in relatively poor adaptability in online applications, and in particular, a temperature change of the battery in use and battery attenuation are not considered in this method.

The method of predicting the peak power of the battery based on the dynamic electrochemical model of the battery fails to dynamically identify a parameter of a battery model. During successive sampling cycles, integral calculations need to be introduced into formulas, which causes related calculations more complicated and a substantially increased amount of calculations. Therefore, how to predict the peak power of the battery accurately using a more advanced method is a problem to be solved, so as to effectively avoid the over charge and over discharge phenomena of the power battery and protect the battery better while reducing complexity of prediction models and the amount of calculations.

On this basis, the present application provides a method and device for predicting a peak power of a battery to achieve accurate prediction of the peak power of the battery.

A method for predicting a peak power of a battery provided in the embodiments of the present application will be described in detail below with reference to the drawings.

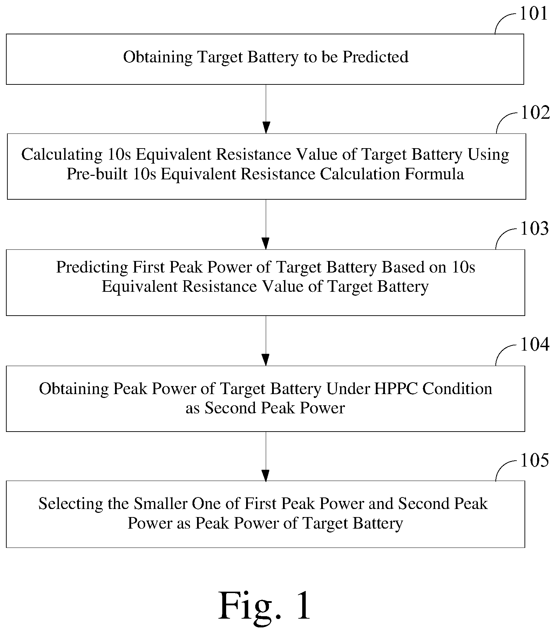

Referring to FIG. 1, which illustrates a flowchart of a method for predicting a peak power of a battery provided in an embodiment of the present application, this embodiment can comprise the following steps:

S101: a target battery to be predicted is obtained.

In this embodiment, any power battery on which prediction of a peak power is performed with this embodiment is defined as a target battery. **To** achieve an object of accurately predicting the peak power of the target battery, the embodiment starts with an existing first-order RC model and the peak power of the target battery is predicted using the subsequent steps S102-S105.

S102: a 10s equivalent resistance value of the target battery is calculated using a pre-built 10s equivalent resistance calculation formula.

In this embodiment, after the target battery to be predicted is obtained in step S101, the 10s equivalent resistance value of the target battery can be calculated out using the pre-set 10s equivalent resistance calculation formula. Among these, the 10s equivalent resistance calculation formula can be built through the following steps A1-A3:

Step A1: a dynamic model of a power battery system is built based on the first-order RC power battery model.

In this embodiment, firstly, a first-order RC model which is not very complicated but guarantees accuracy requirements of use is selected according to needs from an internal resistance model, the first-order RC model and a second-order RC model in traditional dynamic characteristic modeling for the power battery, and is used as a power battery model to build the dynamic model of the power battery system.

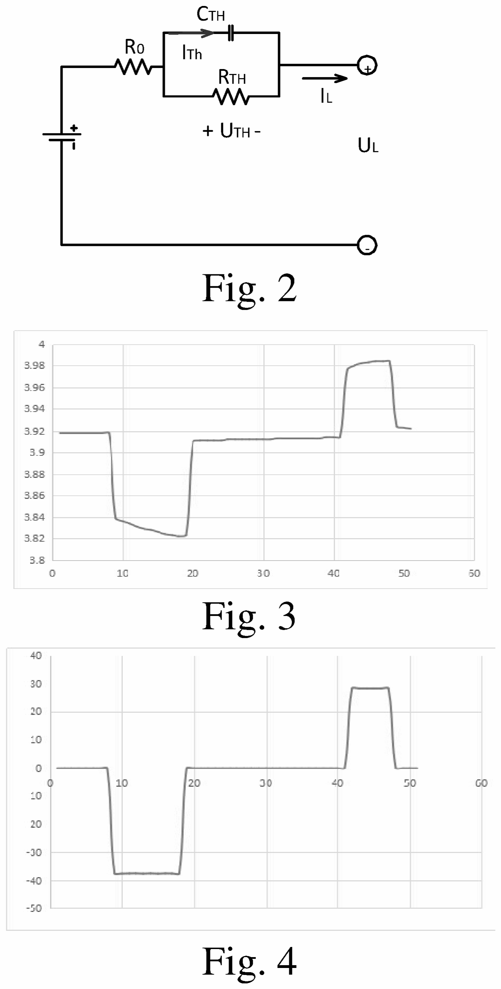

Specifically, referring to FIG. 2, which shows a schematic diagram of a power battery model provided in an embodiment of the present application. This model is used as the dynamic model of the power battery system, in which $U_{ocv}$ represents an open circuit voltage of the target battery; a resistance $R_0$ represents an ohmic internal resistance of the target battery; and $R_{Th}$ and $C_{Th}$ are used to describe a polarization effect of the target battery. The OCV is shown in FIG. 2 by a non-linear function, which is a function of a SOC parameter. With this battery model, description equations can be written as follows:

$$\begin{cases} U_L = U_{oc} - U_{Th} - I_L R_0 \\ \dot{U} = -\dfrac{U_{Th}}{R_{Th} C_{Th}} + \dfrac{I_L}{C_{Th}} \end{cases} \tag{1}$$

$$U_k = OCV(SOC_k) \tag{2},$$

in which, $SOC_k$ represents a SOC value of the target battery at a time k; $\Delta t$ is a sampling cycle during the model is discretized; $R_{Th}$ and $C_{Th}$ are parameters of the polarization effect, respectively; $U_{Th}$ is a voltage across LC in FIG. 1; $U_L$ is a terminal voltage of the target battery; $I_L$ represents a current excitation; and $OCV(SOC_k)$ represents an open circuit voltage of the battery under the current SOC.

Step A2: a difference equation of the dynamic model of the power battery system is obtained as a model formula of the dynamic model of the power battery system.

After the dynamic model of the power battery system is built in step A1, the difference equation of the model needs to be derived in order to accurately predict the peak power of the target battery.

In cases of zero input, with $\tau$ representing a time constant, a voltage decay formula from times k to k + 1 is written as follows:

$$\mathrm{U}_{Th,k+1zeroinputcomponent} = \mathrm{U}_{Th,k} e^{-\frac{\Delta t}{\tau}} \tag{3}.$$

In cases of zero state, with an initial voltage of a capacitor being 0, the voltage decay formula from times k to k + 1 is written as follows:

$$\mathrm{U}_{Th,k+1zerostatecomponent} = (1 - e^{-\frac{\Delta t}{\tau}})R_{Th}I_{L,k} \tag{4}.$$

The following formula can be derived on the basis that a full response is a sum of a zero input response and a zero state response:

$$\begin{cases} \mathrm{U}_{L,k} = U_{oc,k} - U_{Th,k} - I_{L,k}R_0 \\ U_{Th,k+1} = e^{-\frac{\Delta t}{\tau}}U_{Th,k} + (1 - e^{-\frac{\Delta t}{\tau}})R_{Th}I_{L,k} \end{cases} \tag{5}.$$

**Assuming** that $\mathrm{U}_{d,k}$ is a dynamic voltage, and $\mathrm{U}_{d,k} = U_{L,k} - U_{oc,k}$, when putting them into the above formulas (4) and (5), the following formula can be obtained:

$$\begin{aligned} \mathrm{U}_{d,k+1} &= -\left[ e^{-\frac{\Delta t}{\tau}}U_{Th,k} + (1 - e^{-\frac{\Delta t}{\tau}})R_{Th}I_{L,k} \right] - I_{L,k+1}R_0 \\ &= -\left[ e^{-\frac{\Delta t}{\tau}}(U_{oc,k} - U_{L,k} - I_{L,k}R_0) + (1 - e^{-\frac{\Delta t}{\tau}})R_{Th}I_{L,k} \right] - I_{L,k+1}R_0 \\ &= e^{-\frac{\Delta t}{\tau}}U_{d,k} + (-R_0)I_{L,k+1} + \left[ e^{-\frac{\Delta t}{\tau}}R_0 - (1 - e^{-\frac{\Delta t}{\tau}})R_{Th} \right]I_{L,k} \end{aligned} \tag{6}.$$

Then, the difference equation of the dynamic model of the power battery system can be obtained as follows:

$$\mathrm{U}_{d,k+1} = aU_{d,k} + bI_{L,k+1} + cI_{L,k} \tag{7}.$$

The above formula (7) can be used as the model formula of the dynamic model of the power battery system.

Step A3: the 10s equivalent resistance calculation formula is obtained based on the model formula of the dynamic model of the power battery system using a constant current iteration method.

After the model formula (i.e., the formula (7)) of the dynamic model of the power battery system is obtained in step A2, online estimation of a system state variable can be performed using recursive least squares algorithm of a forgetting factor.

A basic concept of the recursive algorithm is, during the recursive algorithm is executed by an identification system, to correct a result estimated last time with a new set of observed data which is newly obtained using the recursive algorithm, to recursively obtain a new estimated parameter value. In this way, as the new observed data is introduced in succession, parameter estimation process repeats until the estimated parameter value approximates an actual value. Therefore, the basic concept of the recursive least square algorithm can be summarized as: a value estimated this time= a value estimated last time + a correction term.

That is, the new estimated value is obtained by correcting the value estimated last time with the new observed data based on the value estimated last time. The estimated parameter value is: $\theta_{LS} = (H_L^T H_L)^{-1} H_L^T Z_L$ .

Given a matrix $P_k = (H_L^T H_L)^{-1}$ , a calculation formula of $P_k$ can be written as follows:

$$
\begin{aligned}
P(k) &= \left( \left[ H_{k-1}^T h(k) \right] \left[ H_{k-1}^T h(k) \right] \right)^{-1} \\
&= \left[ H_{k-1}^T H_{k-1} + h(k)h^T(k) \right]^{-1} \\
&= \left[ P^{-1}(k-1) + h(k)h^T(k) \right]^{-1}
\end{aligned}
\tag{8}.
$$

Then, the following matrix inversion formula is used:

$$
\begin{aligned}
P(k) &= \left[ P^{-1}(k-1) + h(k)h^T(k) \right]^{-1} \\
&= P(k-1) - P(k-1)h(k)\left[ 1 + h^T(k)P(k-1)h(k) \right]^{-1} \times h^T(k)P(k-1) \\
&= \left[ I - \frac{P(k-1)h(k)h^T(k)}{1 + h^T(k)P(k-1)h(k)} \right]P(k-1)
\end{aligned}
\tag{9},
$$

in which the matrix inversion formula is (wherein A, C are invertible square matrices):

$$
(A + BCD)^{-1} = A^{-1} - A^{-1}B(C^{-1} + DA^{-1}B)^{-1}DA^{-1} .
$$

The new parameter value is obtained by correcting the old parameter value with the recursive formula of the parameter being:

$$
\begin{aligned}
\hat{\theta}_{LS,k} &= P(k)\left[ H_{k-1}^T h(k) \right]\left[ Z^T(k-1)z(k) \right]^T \\
&= P(k)\left[ H_{k-1}^T Y(k-1) + h(k)z(k) \right] \\
&= P(k)\left[ P^{-1}(k-1)\hat{\theta}_{LS,k-1} + h(k)z(k) \right] \\
&= P(k)\left\{ \left[ P^{-1}(k) - h(k)h^T(k) \right]\hat{\theta}_{LS,k-1} + h(k)z(k) \right\} \\
&= \hat{\theta}_{LS,k-1} + P(k)h(k)\left[ z(k) - h^T(k)\hat{\theta}_{LS,k-1} \right]
\end{aligned}
\tag{10}.
$$

Then, the following least squares recursive formula can be derived based on the above:

$$
\begin{cases}
\hat{\theta}_{LS,k} = \hat{\theta}_{LS,k-1} + G(k)(z_k - h_k^T \hat{\theta}_{LS,k-1}) \\
G(k) = \dfrac{P(k-1)h(k)}{1 + h(k)^T P(k-1)h(k)} \\
P(k) = P(k-1) - G(k)h(k)^T P(k-1)
\end{cases}
\tag{11}.
$$

It should be noted that, in the above calculations, in order to better ensure timeliness of the data and avoid data saturation so that estimated parameters a, b, and c are more time-effective, a forgetting factor is introduced into the calculations in this embodiment, a forgetting time constant T being expressed as: $T = \dfrac{1}{1-\lambda}$ .

Further, parameter estimation matrices of the forgetting factor can be obtained as follows:

$$\begin{cases} \hat{\theta}_{LS,k} = \hat{\theta}_{LS,k-1} + G(k)\,(z_k - h_k^T\,\hat{\theta}_{LS,k-1}) \\ \quad G(k) = \dfrac{P(k-1)h(k)}{\lambda + h(k)^T P(k-1)h(k)} \\ P(k) = \dfrac{1}{\lambda}\,P(k-1) - G(k)h(k)^T P(k-1) \end{cases} \quad (12),$$

in which the matrix P can be used to determine whether the parameter estimation is stable. Upon acquiring the online parameters, the formula (7) can be used again with a given constant current input to calculate the 10s equivalent resistance calculation formula.

In particular, in a HPPC test of a lithium-ion power battery, a 10s peak charge and discharge power can be obtained through calculation by supplying a still standing battery a constant charge and discharge current for 10s (details about the specific current and voltage, see FIGs. 3 and 4).

On this basis, it is assumed that a given constant current I starts to be supplied at an initial moment, and the current at a previous moment is 0. For the lithium-ion power battery in which its terminal voltage is equal to its interruption voltage and thus Ud is 0 at the initial moment, the 10s equivalent resistance calculation formula is derived as follows using the constant current iteration method:

$$R = a^{10}b + (a^9 + a^8 + a^7 + a^6 + a^5 + a^4 + a^3 + a^2 + a + 1)\,(b + c) \quad (13),$$

and the specific values of the parameters a, b, and c can be estimated using the least squares parameters of the forgetting factor.

Based on this, in a possible implementation of this embodiment, step S102 in which the 10s equivalent resistance value of the target battery is calculated out using the pre-built 10s equivalent resistance calculation formula may include the following steps B1-B2:

Step B1: the parameter values in the 10s equivalent resistance calculation formula are obtained using the recursive least squares algorithm of the forgetting factor.

In this implementation, the recursive least squares algorithm of the forgetting factor and the above formula (7) can be used to calculate the parameter values a, b, and c in the 10s equivalent resistance calculation formula (13). Giving and putting $\theta = (a, b, c)T$, $h(k) = (U_{d,k-1}, I_{L,k}, I_{L,k-1})$ into the above formula (12), the parameter values a, b, and c in the 10s equivalent resistance calculation formula can be calculated out.

In particular, an initialization process is performed firstly, and initial values of internal state variables of the target battery are set up according to the best estimation to a body of the target battery or parameter values which are obtained at the time of last shutdown. For example, $\theta(0)$ and $P(0)$ can be defined by experience.

It is be noted that, in this embodiment, the following assumptions are given: Lamda $= 0.995 \sim 0.999$, $U_{min}$=umin, and $U_{max}$=umax, and then the definitions of $\theta(0)$ and P(0) can be written as:

$$\theta(0) = (0,0,0)T, \quad P(0) = \begin{bmatrix} 10\hat{\ }6 & 0 & 0 \\ 0 & 10\hat{\ }6 & 0 \\ 0 & 0 & 10\hat{\ }6 \end{bmatrix}.$$

**Then,** the following are assigned in the initialization process: $U_0 = OCV(SOC_0)$, and

$$b = \begin{bmatrix} b1 & 0 & 0 \\ 0 & b2 & 0 \\ 0 & 0 & b3 \end{bmatrix}.$$

Then, the description equation of the dynamic model of the power battery system can be used, in combination with a working current, to determine a prediction result in the current state.

Then, the prediction result can be updated with that newly obtained in the current state as well as the current working voltage and current of the battery, so that adaptive parameters are more in line with the current working state.

An online recursion calculation formula is written as:

$$h = \begin{bmatrix} U_d(k-1) \\ I(k) \\ I(k-1) \end{bmatrix} \tag{14}$$

$$K = P * h / (Lamda + h' * P * h) \tag{15}$$

$$b = b + K * (ud(k) - h' * b) \tag{16}$$

$$P = \left( \begin{bmatrix} 1 & 0 & 0 \\ 0 & 1 & 0 \\ 0 & 0 & 1 \end{bmatrix} - K * h' \right) * P / Lamda \tag{17}$$

$$U_k = OCV(SOC_k) \tag{18}.$$

Step B2: the 10s equivalent resistance value of the target battery is calculated using the parameter value in the 10s equivalent resistance calculation formula.

Specifically, after the parameter values a, b, and c in the 10s equivalent resistance calculation formula are obtained in step B1, the 10s internal resistance can be estimated directly by using the obtained parameters and deriving an expression of the 10s resistance value with reference to the identification parameters with a given current, without calculating a DC resistance value, a polarization resistance value and a polarization capacitance value.

Provided that a current is 0 initially at a previous time and an initial dynamic voltage is 0, and the two are put into the formula (7), using the iterative recursive method and given that the current is subjected to a constant current I excitation, a dynamic voltage formula after 10s will be:

$$U_d = (a^{10}b + (a^9 + a^8 + a^7 + a^6 + a^5 + a^4 + a^3 + a^2 + a + 1)(b + c)) * I \tag{19},$$

and then, the 10s equivalent resistance $R_d$ of the target battery can be calculated out as follows:

$$R_d = a^{10}b + (a^9 + a^8 + a^7 + a^6 + a^5 + a^4 + a^3 + a^2 + a + 1)(b + c).$$

Compared with the following existing calculation formula:

$$\begin{cases} R_0 = -b \\ R_{Th} = \dfrac{ab + c}{a - 1} \\ C_{Th} = \dfrac{(1 - a)\Delta t}{(ab + c)\log(a)} \end{cases} \tag{20},$$

the calculation formula of the 10s equivalent resistance value $R_d$ of the target battery obtained in the above calculation process in this embodiment is $R_d = a^{10}b + (a^9 + a^8 + a^7 + a^6 + a^5 + a^4 + a^3 + a^2 + a + 1)(b + c)$, which therefore results in a highly improved calculating speed and a substantially reduced amount of calculations, with no calculations related with circuit relationships involved.

It is be noted that, in an optional implementation, before using the pre-built 10s equivalent resistance calculation formula to calculate the 10s equivalent resistance value of the target battery, this embodiment may also comprise the following steps C1- C3:

Step C1: determining whether the estimated parameter value of the target battery is stable. In this implementation, the matrix P can be used to determine whether the estimated parameter have reached a stable state. If so, step C2 is performed; and if not, step C3 is performed.

Step C2: If it is determined that the estimated parameter value of the target battery is stable, the above step S102 can be performed in which the 10s equivalent resistance value of the target battery is calculated using the pre-built 10s equivalent resistance calculation formula. Step C3: If it is determined that the estimated parameter value of the target battery is unstable, the subsequent step S104 can be performed.

S103: the first peak power of the target battery is predicted based on the 10s equivalent resistance value of the target battery.

In this embodiment, after the 10s equivalent resistance value $R_d$ of the target battery is calculated out in step S102, the peak power of the target battery can be predicted based on the 10s equivalent resistance value $R_d$ of the target battery and defined as the first peak power. Specifically, in a possible implementation of this embodiment, the implementation of the step S103 in which the first peak power of the target battery is predicted based on the 10s equivalent resistance value of the target battery can comprise the following steps D1- D4:

Step D1: a rated voltage of the target battery is obtained and defined as $U_{max}$.

Step D2: a cut-off voltage of the target battery is obtained and defined as $U_{min}$.

Step D3: a maximum charge current and a maximum discharge current of the target battery are calculated based on the 10s equivalent resistance value $R_d$ of the target battery, the rated voltage $U_{max}$ of the target battery and the cut-off voltage $U_{min}$ of the target battery.

In this implementation, if the maximum discharge current of the target battery is defined as $Id_{dis}$ and the maximum charge current of the target battery is defined as $Id_{cha}$, their specific calculation formulas will be:

$$\begin{cases} \mathrm{Id}_{dis} = \dfrac{\mathrm{u}_{min} - U_{ocv}}{R_d} \\ Id_{cha} = \dfrac{u_{max} - U_{ocv}}{R_d} \end{cases} \qquad (21).$$

Step D4: the first peak power of the target battery is predicted based on the maximum charge current $Id_{cha}$, the maximum discharge current $Id_{dis}$ of the target battery and the 10s equivalent resistance value $R_d$ of the target battery.

In this implementation, the predicted first peak power of the target battery is defined as Power, and its specific calculation formula is written as:

$$\begin{aligned} \mathrm{Power} &= Id_{dis} * u_{min} \\ Power &= Id_{cha} * u_{max} \end{aligned} \qquad (22)$$

S104: the peak power of the target battery under the HPPC condition is obtained as the second peak power.

In this embodiment, the real-time SOC of the target battery can be calculated using the current and ampere-hour integration method, and then the peak power of the target battery under the HPPC condition can be obtained with a SOC-Power diagram which is calibrated in advance and the linear interpolation look-up table. This peak power is defined as the second peak power.

It should be noted that the order in which the steps S102-S103 and S104 are performed is not limited in this application. Instead, the first peak power can be obtained before the second peak power, or the second peak power can be obtained before the first peak power. Alternatively, the first peak power and the second peak power can be obtained at the same time.

S105: the smaller one of the first peak power and the second peak power is selected as the peak power of the target battery.

In this embodiment, upon obtaining the first peak power in step S103 and obtaining the second peak power in step S104, the two can be compared and the smaller one is taken as the predicted final peak value of the target battery and will be used in a lithium-ion battery management system (BMS).

In summary, in the method for predicting the peak power of the battery provided in the embodiment of the present application, upon obtaining the target battery to be detected, the 10s equivalent resistance value of the target battery is

**EP 3 736 585 B1**

calculated based on the pre-built 10s equivalent resistance calculation formula. Based on the 10s equivalent resistance value, the first peak power of the target battery is predicted, and at the same time, the peak power of the target battery under the HPPC condition can be obtained as the second peak power. Further, the smaller one of the first and second peak powers can be selected and defined as the peak power of the target battery. It can be seen that, instead of using the existing offline test table method which involves a large amount of calculations and a low prediction accuracy or the prediction method which is based on the dynamic electrochemical model of the battery, the prediction of the peak power of the target battery in the embodiments of the present application is achieved by calculating the 10s equivalent resistance value of the target battery based on the pre-built 10s equivalent resistance calculation formula first, then predicting the 10s peak power of the target battery based on the resistance value, and finally comparing the predicted result with the peak power of the target battery under the HPPC condition to obtain the final 10s peak power of the target battery. This can avoid the over charge and over discharge phenomena of the target battery and protect the target battery better.

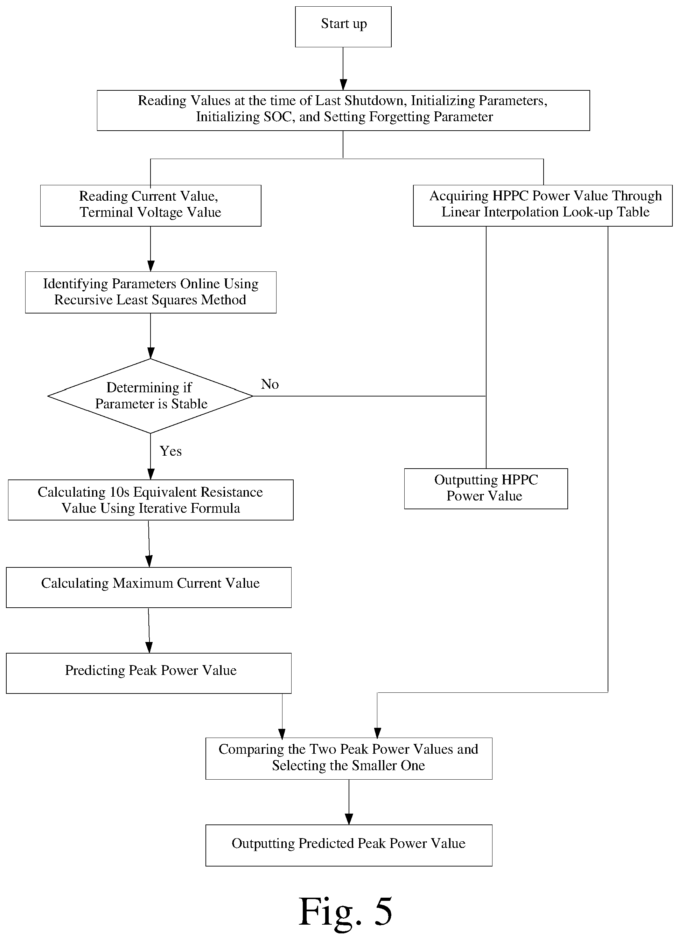

For ease of understanding, with reference to FIG. 5 which is an overall schematic diagram for implementing a method for predicting a peak power of a battery provided in an embodiment of the present application, the overall implementation process of the method for predicting the peak power of the battery provided in the embodiment of the present application will be described below.

As shown in FIG. 5, the process of the embodiment of the present application comprise selecting a first-order RC model of an equivalent circuit, analyzing relationship between a circuit response and a measured current and voltage, and building a system model formula, i.e. the above formula (7); initializing a system parameter and a battery SOC value, reading the parameter and the SOC value at the time of last shutdown, setting up a forgetting factor, acquiring an actually measured current, inputting a terminal voltage into the system, and using the formulas (15) and (16) to recurse the parameter. The process further comprises determining whether the estimated parameter value is stable using the matrix P in the formula (17). At the same time, the real-time SOC of the target battery is calculated using the current and ampere-hour integration method, and the peak power of the target battery under a HPPC condition is obtained using a linear interpolation look-up table and a pre-calibrated SOC-Power diagram. If the parameter value is determined to be unstable by P, the power value under the HPPC condition is directly output as the peak power of the target battery. If the parameter value is determined to be stable by P, the obtained parameter is put into the formula (13) to calculate out the 10s equivalent resistance value of the target battery, and this resistance value is in turn put into the formula (21) to calculate out a maximum charge current and a maximum discharge current of the target battery. Then, the formula (22) can then be used to calculate the peak power of the target battery. Comparison is made between the peak power and the peak power value of the target battery under the HPPC condition, and the smaller one is taken as the predicted final peak power of the target battery. In the same way, the process of estimating the parameter value is repeated. The 10s peak power value of the target battery begins to be estimated again. For details of specific implementation process, please refer to the steps S101 to S105.

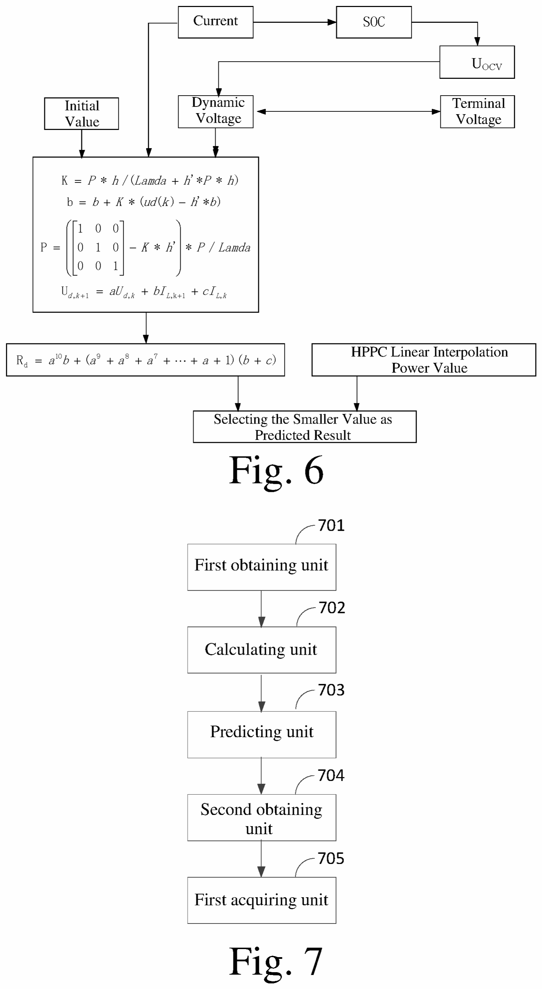

FIG. 6 is a detail schematic diagram of an algorithm for predicting a peak power of a battery. The technical solution of the method of the present application has been described in detail in the above embodiments. Correspondingly, the present application also provides a device for predicting a peak power of a battery, which is described below.

Referring to FIG. 7, in which a schematic diagram of a device for predicting a peak power of a battery provided in this embodiment is shown. The device comprises:

a first obtaining unit 701 configured for obtaining a target battery to be predicted;
a calculating unit 702 configured for calculating a 10s equivalent resistance value of the target battery using a pre-built 10s equivalent resistance calculation formula;
a predicting unit 703 configured for predicting a first peak power of the target battery based on the 10s equivalent resistance value of the target battery;
a second obtaining unit 704 configured for obtaining the peak power of the target battery under a HPPC condition as a second peak power; and
a first acquiring unit 705 configured for selecting a smaller one of the first peak power and the second peak power as the peak power of the target battery.

In an implementation of this embodiment, the device further comprises:

a building unit for building a dynamic model of a power battery system based on a first-order RC power battery model;
a third obtaining unit configured for obtaining a difference equation of the dynamic model of the power battery system as a model formula of the dynamic model of the power battery system; and
the second acquiring unit configured for acquiring the 10s equivalent resistance calculation formula based on the model formula of the dynamic model of the power battery system using a constant current iteration method.

In an implementation of this embodiment, the calculating unit 702 comprises: a parameter value determining

12

subunit configured for acquiring a parameter value in the 10s equivalent resistance calculation formula using a recursive least squares algorithm of a forgetting factor; and a resistance value calculating subunit configured for calculating the 10s equivalent resistance value of the target battery using the parameter value in the 10s equivalent resistance calculation formula.

In an implementation of this embodiment, the device further comprises:

a determining unit configured for determining whether the estimated parameter value of the target battery is stable, wherein the calculating unit is used to calculate the 10s equivalent resistance value of the target battery if the estimated parameter value of the target battery is determined to be stable, and the second obtaining unit is used to obtain the peak power of the target battery under the HPPC condition if the estimated parameter value of the target battery is determined to be unstable.

In an implementation of this embodiment, the predicting unit 703 includes: a first obtaining subunit configured for obtaining a rated voltage of the target battery; a second obtaining subunit configured for obtaining a cut-off voltage of the target battery; a current calculating subunit configured for calculating a maximum charge current and a maximum discharge current of the target battery based on the 10s equivalent resistance value of the target battery, the rated voltage of the target battery and the cut-off voltage of the target battery; and a power predicting subunit configured for predicting the first peak power of the target battery based on the maximum charge current and the maximum discharge current of the target battery and the 10s equivalent resistance value of the target battery.

In summary, with the device for predicting the peak power of the battery provided in the embodiment of the present application, upon obtaining the target battery to be detected, the 10s equivalent resistance value of the target battery is calculated based on the pre-built 10s equivalent resistance calculation formula. Based on the 10s equivalent resistance value, the first peak power of the target battery is predicted, and at the same time, the peak power of the target battery under the HPPC condition can be obtained as the second peak power. Further, the smaller one of the first and second peak powers can be selected and defined as the peak power of the target battery. It can be seen that, instead of using the existing offline test table method which involves a large amount of calculations and a low prediction accuracy or the prediction method which is based on the dynamic electrochemical model of the battery, the prediction of the peak power of the target battery in the embodiments of the present application is achieved by calculating the 10s equivalent resistance value of the target battery based on the pre-built 10s equivalent resistance calculation formula first, then predicting the 10s peak power of the target battery based on the resistance value, and finally comparing the predicted result with the peak power of the target battery under the HPPC condition to obtain the final 10s peak power of the target battery. This can avoid the over charge and over discharge phenomena of the target battery and protect the target battery better.

It can be known from the description of the foregoing embodiments that those skilled in the art can clearly understand that all or part of the steps in the method of the above embodiments can be implemented by means of a software as well as a necessary universal hardware platform. Based on such an understanding, the technical solutions of this application essentially or parts that contribute to the existing technology can be embodied in the form of a software product. The computer software product can be stored in a storage medium, such as ROM/RAM, a magnetic disk , an optical disc, etc., which includes a number of instructions that cause a computer device (which may be a personal computer, a server, or a network communication device such as a media gateway, etc.) to perform the method described in the various embodiments of this application or parts thereof.

It should be noted that the embodiments in this specification are described in a progressive manner. Each embodiment is described and focused on its differences from other embodiments, while the same or similar parts between the various embodiments may refer to one another. The device disclosed in the embodiments is described relatively simple since it corresponds to the method disclosed in the embodiments and the description of the method can be referred to with regard to the relevant parts.

It should also be noted that, throughout the context, terms such as first, second etc. are merely used to distinguish one entity or operation from another, and do not necessarily require or imply any actual relationship or order between these entities or operations. Moreover, terms "including", "comprising" or any other variations thereof are intended to encompass non-exclusive inclusion, so that a process, method, article or device that includes a series of elements includes not only those elements but also other elements that are not explicitly listed or other elements inherent to the process, method, article, or device. Without more restrictions, an element defined by a phrase "including a/an ..." do not exclude existence of other identical elements in the process, method, article, or equipment including the element.

The above description of the disclosed embodiments enables those skilled in the art to implement or use the present application. Various modifications to these embodiments are apparent to those skilled in the art, and the general principles defined herein can be implemented in other embodiments without departing from the scope of the application. Therefore, this application will not be limited to the embodiments shown herein, but shall conform to the widest scope consistent with the principles and novel features disclosed herein.

**Claims**

1. A method for predicting a peak power of a battery, comprising:

providing a target battery to be predicted;
calculating a 10s equivalent resistance value of the target battery using a pre-built 10s equivalent resistance calculation formula;
predicting a first peak power of the target battery based on the 10s equivalent resistance value of the target battery;
calculating the peak power of the target battery under a HPPC condition as a second peak power; and
selecting the smaller one of the first peak power and the second peak power as the peak power of the target battery,
wherein building the 10s equivalent resistance calculation formula comprises:

providing a first-order RC power battery model as a dynamic model of a power battery system;
deriving the following difference equation of the dynamic model of the power battery system as a model formula of the dynamic model of the power battery system:

$$U_{d,k+1} = aU_{d,k} + bI_{L,k+1} + cI_{L,k};$$

and
deriving the following 10s equivalent resistance calculation formula based on the model formula of the dynamic model of the power battery system using a constant current iteration method:

$$R = a^{10}b + (a^9 + a^8 + a^7 + a^6 + a^5 + a^4 + a^3 + a^2 + a + 1)(b + c),$$

wherein calculating the 10s equivalent resistance value of the target battery using the pre-built 10s equivalent resistance calculation formula comprises:

calculating parameter values a, b and c in the 10s equivalent resistance calculation formula using a recursive least squares algorithm of a forgetting factor; and
calculating the 10s equivalent resistance value of the target battery by putting the parameter values into the 10s equivalent resistance calculation formula, and
wherein predicting the first peak power of the target battery based on the 10s equivalent resistance value of the target battery comprises:

calculating a maximum charge current and a maximum discharge current of the target battery based on the 10s equivalent resistance value of the target battery $R_d$, a rated voltage of the target battery $U_{max}$ and a cut-off voltage of the target battery $U_{min}$, and an open circuit voltage of the target battery $U_{ocv}$, wherein the maximum discharge current $Id_{dis}$ and maximum charge current $Id_{cha}$ are calculated by:

$$Id_{dis} = \frac{U_{min} - U_{ocv}}{R_d},$$

$$Id_{cha} = \frac{U_{max} - U_{ocv}}{R_d},$$

and
predicting the first peak power of the target battery based on the maximum charge current and the maximum discharge current of the target battery and the 10s equivalent resistance value of the target battery, wherein the predicted first peak power is calculated by:

$$Power = Id_{dis} * U_{min}$$

$$Power = Id_{cha} * U_{max}.$$

2. The method according to claim 1, **characterized by**, before calculating the 10s equivalent resistance value of the target battery using the pre-built 10s equivalent resistance calculation formula, further comprising:

determining whether the calculated parameter values of the target battery are stable;
performing the step of calculating the 10s equivalent resistance value of the target battery using the pre-built 10s equivalent resistance calculation formula if the calculated parameter values of the target battery are stable; and
performing the step of obtaining the peak power of the target battery under the HPPC condition if the calculated parameter values of the target battery are unstable.

3. A device for predicting a peak power of a battery, comprising:

a first obtaining unit configured for providing a target battery to be predicted;
a calculating unit configured for calculating a 10s equivalent resistance value of the target battery using a pre-built 10s equivalent resistance calculation formula;
a predicting unit configured for predicting a first peak power of the target battery based on the 10s equivalent resistance value of the target battery;
a second obtaining unit configured for calculating the peak power of the target battery under a HPPC condition as the second peak power;
a first acquiring unit configured for selecting the smaller one of the first peak power and the second peak power as the peak power of the target battery;
a building unit for providing a first-order RC power battery model as a dynamic model of a power battery system;
a third obtaining unit configured for deriving the following difference equation of the dynamic model of the power battery system as a model formula of the dynamic model of the power battery system:

$$U_{d,k+1} = aU_{d,k} + bI_{L,k+1} + cI_{L,k};$$

and
a second acquiring unit configured for deriving the following 10s equivalent resistance calculation formula based on the model formula of the dynamic model of the power battery system using a constant current iteration method:

$$R = a^{10}b + (a^9 + a^8 + a^7 + a^6 + a^5 + a^4 + a^3 + a^2 + a + 1)(b + c),$$

wherein the calculating unit comprises:

a parameter value determining subunit configured for calculating parameter values a, b and c in the 10s equivalent resistance calculation formula using a recursive least squares algorithm of a forgetting factor; and
a resistance value calculating subunit configured for calculating the 10s equivalent resistance value of the target battery by putting the parameter values into the 10s equivalent resistance calculation formula, and wherein the predicting unit comprises:

a current calculating subunit configured for calculating a maximum charge current and a maximum discharge current of the target battery based on the 10s equivalent resistance value of the target battery $R_d$, a rated voltage of the target battery $U_{max}$ and a cut-off voltage of the target battery $U_{min}$, and an open circuit voltage of the target battery $U_{ocv}$, wherein the maximum discharge current $Id_{dis}$ and maximum charge current $Id_{cha}$ are calculated by:

$$Id_{dis} = \frac{U_{min} - U_{ocv}}{R_d},$$

$$Id_{cha} = \frac{U_{max} - U_{ocv}}{R_d},$$

and
a power predicting subunit configured for predicting the first peak power of the target battery based on the maximum charge current and the maximum discharge current of the target battery and the 10s equivalent resistance value of the target battery, wherein the predicted first peak power is calculated by:

$$Power = Id_{dis} * U_{min}$$

$$Power = Id_{cha} * U_{max}.$$

4. The device according to claim 3, **characterized in that** the device further comprises:
a determining unit configured for determining whether the calculated parameter values of the target battery are stable, wherein the calculating unit is used to calculate the 10s equivalent resistance value of the target battery if the calculated parameter values of the target battery are determined to be stable, and the second obtaining unit is used to obtain the peak power of the target battery under the HPPC condition if the calculated parameter values of the target battery are determined to be unstable.

**Patentansprüche**

1. Verfahren zur Vorhersage einer Spitzenleistung einer Batterie, umfassend:

Bereitstellen einer vorherzusagenden Zielbatterie;
Berechnen eines 10s-äquivalenten Widerstandswertes der Zielbatterie unter Verwendung einer vorgebauten 10s-äquivalenten Widerstandsberechnungsformel;
Vorhersagen einer ersten Spitzenleistung der Zielbatterie basierend auf dem 10s-äquivalenten Widerstandswert der Zielbatterie;
Berechnen der Spitzenleistung der Zielbatterie unter einer HPPC-Bedingung als eine zweite Spitzenleistung; und
Auswählen der kleineren von der ersten Spitzenleistung und der zweiten Spitzenleistung als die Spitzenleistung der Zielbatterie,
wobei das Bauen der 10s-äquivalenten Widerstandsberechnungsformel Folgendes umfasst:

Bereitstellen eines RC-Leistungsbatteriemodells erster Ordnung als dynamisches Modell eines Leistungsbatteriesystems;
Ableiten der folgenden Differenzgleichung des dynamischen Modells des Leistungsbatteriesystems als Modellformel des dynamischen Modells des Leistungsbatteriesystems:

$$U_{d,k+1} = aU_{d,k} + bI_{L,k+1} + cI_{L,k};$$

und
Ableiten der folgenden 10s-äquivalenten Widerstandsberechnungsformel basierend auf der Modellformel des dynamischen Modells des Leistungsbatteriesystems unter Verwendung eines Konstantstromiterationsverfahrens:

$$R = a^{10}b + (a^9 + a^8 + a^7 + a^6 + a^5 + a^4 + a^3 + a^2 + a + 1)(b + c),$$

wobei das Berechnen des 10s-äquivalenten Widerstandswertes der Zielbatterie unter Verwendung der vorgebauten 10s-äquivalenten Widerstandsberechnungsformel Folgendes umfasst:

Berechnen von Parameterwerten a, b und c in der 10s-äquivalenten Widerstandsberechnungsformel unter Verwendung eines rekursiven Kleinste-Quadrate-Algorithmus eines Vergessensfaktors; und Berechnen des 10s-äquivalenten Widerstandswertes der Zielbatterie durch Einsetzen der Parameterwerte in die 10s-äquivalente Widerstandsberechnungsformel, und

wobei das Vorhersagen der ersten Spitzenleistung der Zielbatterie basierend auf dem 10s-äquivalenten Widerstandswert der Zielbatterie Folgendes umfasst:

Berechnen eines maximalen Ladestroms und eines maximalen Entladestroms der Zielbatterie basierend auf dem 10s-äquivalenten Widerstandswert der Zielbatterie Rd, einer Nennspannung der Zielbatterie $U_{max}$ und einer Abschaltspannung der Zielbatterie $U_{min}$ und einer offenen Schaltungsspannung der Zielbatterie $U_{ocv}$, wobei der maximale Entladestrom $Id_{dis}$ und der maximale Ladestrom $Id_{cha}$ berechnet werden durch:

$$Id_{dis} = \frac{U_{min} - U_{ocv}}{R_d},$$

$$Id_{cha} = \frac{U_{max} - U_{ocv}}{R_d},$$

und

Vorhersagen der ersten Spitzenleistung der Zielbatterie basierend auf dem maximalen Ladestrom und dem maximalen Entladestrom der Zielbatterie und dem 10s-äquivalenten Widerstandswert der Zielbatterie, wobei die vorhergesagte erste Spitzenleistung berechnet wird durch:

$$Power = Id_{dis} * U_{min}$$

$$Power = Id_{cha} * U_{max}.$$

2. Verfahren nach Anspruch 1, **dadurch gekennzeichnet, dass** es vor dem Berechnen des 10s-äquivalenten Widerstandswertes der Zielbatterie unter Verwendung der vorgebauten 10s-äquivalenten Widerstandsberechnungsformel ferner Folgendes umfasst:

Bestimmen, ob die berechneten Parameterwerte der Zielbatterie stabil sind;
Durchführen des Schrittes des Berechnens des 10s-äquivalenten Widerstandswertes der Zielbatterie unter Verwendung der vorgebauten 10s-äquivalenten Widerstandsberechnungsformel, wenn die berechneten Parameterwerte der Zielbatterie stabil sind; und
Durchführen des Schrittes des Erhaltens der Spitzenleistung der Zielbatterie unter der HPPC-Bedingung, wenn die berechneten Parameterwerte der Zielbatterie instabil sind.

3. Vorrichtung zur Vorhersage einer Spitzenleistung einer Batterie, umfassend:

eine erste Erhaltungseinheit, die zum Bereitstellen einer vorherzusagenden Zielbatterie konfiguriert ist;
eine Berechnungseinheit, die zum Berechnen eines 10s-äquivalenten Widerstandswertes der Zielbatterie unter Verwendung einer vorgebauten 10s-äquivalenten Widerstandsberechnungsformel konfiguriert ist;
eine Vorhersageeinheit, die zum Vorhersagen einer ersten Spitzenleistung der Zielbatterie basierend auf dem 10s-äquivalenten Widerstandswert der Zielbatterie konfiguriert ist;
eine zweite Erhaltungseinheit, die zum Berechnen der Spitzenleistung der Zielbatterie unter einer HPPC-Bedingung als die zweite Spitzenleistung konfiguriert ist;
eine erste Erfassungseinheit, die zum Auswählen der kleineren von der ersten Spitzenleistung und der zweiten Spitzenleistung als die Spitzenleistung der Zielbatterie konfiguriert ist;
eine Baueinheit zum Bereitstellen eines RC-Leistungsbatteriemodells erster Ordnung als dynamisches Modell eines Leistungsbatteriesystems;
eine dritte Erhaltungseinheit, die zum Ableiten der folgenden Differenzgleichung des dynamischen Modells des Leistungsbatteriesystems als Modellformel des dynamischen Modells des Leistungsbatteriesystems konfiguriert ist:

$$U_{d,k+1} = aU_{d,k} + bI_{L,k+1} + cI_{L,k};$$

und

eine zweite Erfassungseinheit, die zum Ableiten der folgenden 10s-äquivalenten Widerstandsberechnungsformel basierend auf der Modellformel des dynamischen Modells des Leistungsbatteriesystems unter Verwendung eines Konstantstromiterationsverfahrens konfiguriert ist:

$$R = a^{10}b + (a^9 + a^8 + a^7 + a^6 + a^5 + a^4 + a^3 + a^2 + a + 1)(b + c),$$

wobei die Berechnungseinheit Folgendes umfasst:

eine Parameterwertbestimmungsuntereinheit, die zum Berechnen von Parameterwerten a, b und c in der 10s-äquivalenten Widerstandsberechnungsformel unter Verwendung eines rekursiven Kleinste-Quadrate-Algorithmus eines Vergessensfaktors konfiguriert ist; und
eine Widerstandswertberechnungsuntereinheit, die zum Berechnen des 10s-äquivalenten Widerstandswertes der Zielbatterie durch Einsetzen der Parameterwerte in die 10s-äquivalente Widerstandsberechnungsformel konfiguriert ist, und
wobei die Vorhersageeinheit Folgendes umfasst:

eine Stromberechnungsuntereinheit, die zum Berechnen eines maximalen Ladestroms und eines maximalen Entladestroms der Zielbatterie basierend auf dem 10s-äquivalenten Widerstandswert der Zielbatterie Rd, einer Nennspannung der Zielbatterie $U_{max}$ und einer Abschaltspannung der Zielbatterie $U_{min}$ und einer offenen Schaltungsspannung der Zielbatterie $U_{ocv}$ konfiguriert ist, wobei der maximale Entladestrom $Id_{dis}$ und der maximale Ladestrom $Id_{cha}$ berechnet werden durch:

$$Id_{dis} = \frac{U_{min} - U_{ocv}}{R_d},$$

$$Id_{cha} = \frac{U_{max} - U_{ocv}}{R_d},$$

und

eine Leistungsvorhersageuntereinheit, die zum Vorhersagen der ersten Spitzenleistung der Zielbatterie basierend auf dem maximalen Ladestrom und dem maximalen Entladestrom der Zielbatterie und dem 10s-äquivalenten Widerstandswert der Zielbatterie konfiguriert ist, wobei die vorhergesagte erste Spitzenleistung berechnet wird durch:

$$Power = Id_{dis} * U_{min}$$

$$Power = Id_{cha} * U_{max}.$$

4. Vorrichtung nach Anspruch 3, **dadurch gekennzeichnet, dass** die Vorrichtung ferner Folgendes umfasst:
eine Bestimmungseinheit, die zum Bestimmen konfiguriert ist, ob die berechneten Parameterwerte der Zielbatterie stabil sind, wobei die Berechnungseinheit verwendet wird, um den 10s-äquivalenten Widerstandswert der Zielbatterie zu berechnen, wenn die berechneten Parameterwerte der Zielbatterie als stabil bestimmt werden, und die zweite Erhaltungseinheit verwendet wird, um die Spitzenleistung der Zielbatterie unter der HPPC-Bedingung zu erhalten, wenn die berechneten Parameterwerte der Zielbatterie als instabil bestimmt werden.

**Revendications**

1. Procédé permettant de prédire une puissance de crête d'une batterie, comprenant :

la fourniture d'une batterie cible à prédire ;

le calcul d'une valeur de résistance équivalente sur 10 s de la batterie cible à l'aide d'une formule de calcul de résistance équivalente sur 10 s pré-construite ;

la prédiction d'une première puissance de crête de la batterie cible sur la base de la valeur de résistance équivalente sur 10 s de la batterie cible ;

le calcul de la puissance de crête de la batterie cible dans une condition HPPC en tant que seconde puissance de crête ; et

la sélection de la plus petite puissance parmi la première puissance de crête et la seconde puissance de crête en tant que puissance de crête de la batterie cible,

ladite construction de la formule de calcul de la résistance équivalente sur 10 s comprenant :

la fourniture d'un modèle de batterie d'alimentation RC de premier ordre en tant que modèle dynamique d'un système de batterie de puissance ;

la dérivation de l'équation aux différences suivante du modèle dynamique du système de batterie de puissance en tant que formule de modèle du modèle dynamique du système de batterie de puissance :

$$U_{d,k+1} = aU_{d,k} + bI_{L,k+1} + cI_{L,k} ;$$

et

la dérivation de la formule de calcul de la résistance équivalente sur 10 s suivante basée sur la formule de modèle du modèle dynamique du système de batterie de puissance à l'aide d'une méthode d'itération à courant constant :

$$R = a^{10}b + (a^9 + a^8 + a^7 + a^6 + a^5 + a^4 + a^3 + a^2 + a + 1)(b + c),$$

ledit calcul de la valeur de résistance équivalente sur 10 s de la batterie cible à l'aide de la formule de calcul de résistance équivalente sur 10 s pré-construite comprenant :

le calcul des valeurs de paramètres a, b et c dans la formule de calcul de la résistance équivalente sur 10 s à l'aide d'un algorithme des moindres carrés récursifs d'un facteur d'oubli ; et

le calcul de la valeur de résistance équivalente sur 10 s de la batterie cible en mettant les valeurs de paramètres dans la formule de calcul de résistance équivalente sur 10 s, et

ladite prédiction de la première puissance de crête de la batterie cible sur la base de la valeur de résistance équivalente sur 10 s de la batterie cible comprenant :

calcul d'un courant de charge maximal et d'un courant de décharge maximal de la batterie cible sur la base de la valeur de résistance équivalente sur 10 s de la batterie cible $R_d$, d'une tension nominale de la batterie cible $U_{max}$ et d'une tension de coupure de la batterie cible $U_{min}$, et d'une tension en circuit ouvert de la batterie cible $U_{ocv}$, ledit courant de décharge maximal $Id_{dis}$ et ledit courant de charge maximal $Id_{cha}$ étant calculés par :

$$Id_{dis} = \frac{U_{min} - U_{ocv}}{R_d},$$

$$Id_{cha} = \frac{U_{max} - U_{ocv}}{R_d},$$

et

la prédiction de la première puissance de crête de la batterie cible sur la base du courant de charge maximal et du courant de décharge maximal de la batterie cible et de la valeur de résistance équivalente sur 10 s de la batterie cible, ladite première puissance de crête prédite est calculée par :

$$Power = Id_{dis} * U_{min}$$

$$Power = Id_{cha} * U_{max}.$$

**2.** Procédé selon la revendication 1, **caractérisé par**, avant de calculer la valeur de résistance équivalente sur 10 s de la batterie cible à l'aide de la formule de calcul de résistance équivalente sur 10 s pré-construite, comprenant en outre :

la détermination pour savoir si les valeurs de paramètres calculées de la batterie cible sont stables ;
la réalisation de l'étape de calcul de la valeur de résistance équivalente sur 10 s de la batterie cible à l'aide de la formule de calcul de résistance équivalente sur 10 s pré-construite si les valeurs de paramètres calculées de la batterie cible sont stables ; et
la réalisation de l'étape d'obtention de la puissance de crête de la batterie cible dans la condition HPPC si les valeurs de paramètres calculées de la batterie cible sont instables.

**3.** Dispositif destiné à la prédiction d'une puissance de crête d'une batterie, comprenant :

une première unité d'obtention configurée pour fournir une batterie cible à prédire ;
une unité de calcul configurée pour calculer une valeur de résistance équivalente sur 10 s de la batterie cible à l'aide d'une formule de calcul de résistance équivalente sur 10 s pré-construite ;
une unité de prédiction configurée pour prédire une première puissance de crête de la batterie cible sur la base de la valeur de résistance équivalente sur 10 s de la batterie cible ;
une deuxième unité d'obtention configurée pour calculer la puissance de crête de la batterie cible dans une condition HPPC en tant que seconde puissance de crête ;
une première unité d'acquisition configurée pour sélectionner la plus petite parmi la première puissance de crête et la seconde puissance de crête en tant que puissance de crête de la batterie cible ;
une unité de construction pour fournir un modèle de batterie de puissance RC de premier ordre en tant que modèle dynamique d'un système de batterie de puissance ;
une troisième unité d'obtention configurée pour dériver l'équation aux différences suivante du modèle dynamique du système de batterie de puissance en tant que formule de modèle du modèle dynamique du système de batterie de puissance :

$$U_{d,k+1} = aU_{d,k} + bI_{L,k+1} + cI_{L,k};$$

et
une seconde unité d'acquisition configurée pour dériver la formule de calcul de la résistance équivalente sur 10 s suivante sur la base de la formule de modèle du modèle dynamique du système de batterie de puissance à l'aide d'une méthode d'itération à courant constant :

$$R = a^{10}b + (a^9 + a^8 + a^7 + a^6 + a^5 + a^4 + a^3 + a^2 + a + 1)(b + c),$$

ladite unité de calcul comprenant :

une sous-unité de détermination de valeur de paramètre configurée pour calculer les valeurs de paramètres a, b et c dans la formule de calcul de la résistance équivalente sur 10 s à l'aide d'un algorithme des moindres carrés récursifs d'un facteur d'oubli ; et
une sous-unité de calcul de valeur de résistance configurée pour calculer la valeur de résistance équivalente sur 10 s de la batterie cible en mettant les valeurs de paramètres dans la formule de calcul de résistance équivalente sur 10 s, et
ladite unité de prédiction comprenant :

une sous-unité de calcul de courant configurée pour calculer un courant de charge maximal et un courant de décharge maximal de la batterie cible sur la base de la valeur de résistance équivalente sur 10 s de la batterie cible $R_d$, d'une tension nominale de la batterie cible $U_{max}$ et d'une tension de coupure de la batterie cible $U_{min}$ et d'une tension en circuit ouvert de la batterie cible $U_{ocv}$, ledit courant de décharge maximal $Id_{dis}$ et ledit courant de charge maximal $Id_{cha}$ étant calculés par :

$$Id_{dis} = \frac{U_{min} - U_{ocv}}{R_d},$$

$$Id_{cha} = \frac{U_{max} - U_{ocv}}{R_d},$$

et
une sous-unité de prédiction de puissance configurée pour prédire la première puissance de crête de la batterie cible sur la base du courant de charge maximal et du courant de décharge maximal de la batterie cible et de la valeur de résistance équivalente sur 10 s de la batterie cible, ladite première puissance de crête prédite étant calculée par :

$$Power = Id_{dis} * U_{min}$$

$$Power = Id_{cha} * U_{max}.$$

4. Dispositif selon la revendication 3, **caractérisé en ce que** le dispositif comprend en outre : une unité de détermination configurée pour déterminer si les valeurs de paramètres calculées de la batterie cible sont stables, ladite unité de calcul étant utilisée pour calculer la valeur de résistance équivalente sur 10 s de la batterie cible si les valeurs de paramètres calculées de la batterie cible sont déterminées comme étant stables, et ladite deuxième unité d'obtention étant utilisée pour obtenir la puissance de crête de la batterie cible dans la condition HPPC si les valeurs de paramètres calculées de la batterie cible sont déterminées comme étant instables.

101

Obtaining Target Battery to be Predicted

102

Calculating 10s Equivalent Resistance Value of Target Battery Using Pre-built 10s Equivalent Resistance Calculation Formula

103

Predicting First Peak Power of Target Battery Based on 10s Equivalent Resistance Value of Target Battery

104

Obtaining Peak Power of Target Battery Under HPPC Condition as Second Peak Power

105

Selecting the Smaller One of First Peak Power and Second Peak Power as Peak Power of Target Battery

# Fig. 1

Fig. 2

Fig. 3

Fig. 4

```
                            ┌──────────────┐
                            │   Start up   │
                            └──────┬───────┘
                                   │
                                   ▼
        ┌──────────────────────────────────────────────────────────────┐
        │   Reading Values at the time of Last Shutdown, Initializing    │
        │   Parameters, Initializing SOC, and Setting Forgetting Parameter │
        └──────────────────────────┬───────────────────────────────────┘
                   │                                       │
                   ▼                                       ▼
        ┌────────────────────────┐        ┌──────────────────────────────────┐
        │  Reading Current Value, │        │ Acquiring HPPC Power Value Through │
        │  Terminal Voltage Value │        │  Linear Interpolation Look-up Table │
        └───────────┬────────────┘        └──────────────────┬───────────────┘
                    ▼                                         │
        ┌────────────────────────┐                           │
        │ Identifying Parameters  │                           │
        │ Online Using Recursive  │                           │
        │  Least Squares Method   │                           │
        └───────────┬────────────┘                           │
                    ▼                                         │
                 ╱───────╲          No                        │
               ╱ Determining ╲──────────────────────┐         │
               ╲  if Parameter ╱                     │         │
                 ╲ is Stable ╱                       │         │
                    ╲──┬──╱                          ▼         │
                    Yes │                    ┌──────────────┐  │
                        ▼                    │ Outputting    │  │
        ┌────────────────────────┐          │ HPPC Power    │  │
        │ Calculating 10s         │          │ Value         │  │
        │ Equivalent Resistance   │          └──────┬───────┘  │
        │ Value Using Iterative   │                 │          │
        │ Formula                 │                 │          │
        └───────────┬────────────┘                 │          │
                    ▼                               │          │
        ┌────────────────────────┐                 │          │
        │ Calculating Maximum     │                 │          │
        │ Current Value           │                 │          │
        └───────────┬────────────┘                 │          │
                    ▼                               │          │
        ┌────────────────────────┐                 │          │
        │ Predicting Peak Power   │                 │          │
        │ Value                   │                 │          │
        └───────────┬────────────┘                 │          │
                    │                               │          │
                    ▼                               ▼          │
        ┌──────────────────────────────────────────────────┐  │
        │ Comparing the Two Peak Power Values and           │◀─┘
        │ Selecting the Smaller One                         │
        └───────────────────────┬──────────────────────────┘
                                ▼
        ┌──────────────────────────────────────────────────┐
        │ Outputting Predicted Peak Power Value             │
        └──────────────────────────────────────────────────┘
```

# Fig. 5

$$K = P * h / (Lamda + h' * P * h)$$

$$b = b + K * (ud(k) - h' * b)$$

$$P = \left( \begin{bmatrix} 1 & 0 & 0 \\ 0 & 1 & 0 \\ 0 & 0 & 1 \end{bmatrix} - K * h' \right) * P / Lamda$$

$$U_{d,k+1} = aU_{d,k} + bI_{L,k+1} + cI_{L,k}$$

$$R_d = a^{10}b + (a^9 + a^8 + a^7 + \cdots + a + 1)(b + c)$$

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016052418 A1

- EP 2894486 A1

**Non-patent literature cited in the description**

- **HU XIAOSONG et al.** Model-Based Dynamic Power Assessment of Lithium-Ion Batteries Considering Different Operating Conditions. *IEEE TRANSACTIONS ON INDUSTRIAL INFORMATICS*, 01 August 2014, vol. 10 (3), 1948-1959

- **CAI-PING ZHANG et al.** Estimation of Real-Time Peak Power Capability of a Traction Battery Pack Used in an HEV. *POWER AND ENERGY ENGINEERING CONFERENCE (APPEEC)*, 28 March 2010, 1-6